Europäisches Patentamt

European Patent Office

Office européen des brevets

(11) Veröffentlichungsnummer: **0 278 408 B1**

(12) **EUROPÄISCHE PATENTSCHRIFT**

(45) Veröffentlichungstag der Patentschrift: **25.11.92**

(21) Anmeldenummer: **88101644.8**

(22) Anmeldetag: **04.02.88**

(51) Int. Cl.⁵: **G02B 6/12**, H01L 31/02

(54) **Monolithisch integrierte Wellenleiter-Fotodiodenkombination.**

(30) Priorität: **06.02.87 DE 3703605**

(43) Veröffentlichungstag der Anmeldung:
**17.08.88 Patentblatt 88/33**

(45) Bekanntmachung des Hinweises auf die
Patenterteilung:
**25.11.92 Patentblatt 92/48**

(84) Benannte Vertragsstaaten:
**DE FR GB IT**

(56) Entgegenhaltungen:
**DE-A- 2 624 436**
**US-A- 3 873 828**

**ELECTRONICS LETTERS, Band 21, nr. 9, 25.
April 1985, Seiten 382,383, Stevenage, Herts,
GB, "Monolithic InGaAs photodiode array illuminated through an integrated waveguide"**

**PATENT ABSTRACTS OF JAPAN, Band o Nr.
115 (E-247)(1552), 29. Mai 1984 & JP A
5929472**

**PATENT ABSTRACTS OF JAPAN, Band 11,
Nr. 58 (P-550)(2505), 21. Februar 1987 & JP A
61223807**

**IBM TECHNICAL DISCLOSURE BULLETIN,
Band 20, Nr. 2, Juli 1977, Seite 537; W.B.
ARCHEY: "Optical waveguides built into modules"**

(73) Patentinhaber: **SIEMENS AKTIENGESELL-
SCHAFT**
**Wittelsbacherplatz 2**
**W-8000 München 2(DE)**

(72) Erfinder: **Plihal, Manfred, Dr. rer. nat.**
**Sonnenspitzstrasse 13**
**W-8000 München 82(DE)**

## Beschreibung

Die vorliegende Erfindung betrifft eine monolithisch integrierte Wellenleiter-Fotodiodenkombination zum Einbau in optische Nachrichtensysteme nach dem Oberbegriff des Anspruches 1.

In den Druckschriften Stillman e. a.: "Monolithic integrated $In_xGa_{1-x}As$ Schottky-barrier waveguide photodetector", Appl. Phys. Lett. 25, 36-38 (1974), und Ostrowsky e. a.: "Integrated optical photodetector", Appl. Phys. Lett. 22, 463-464 (1973), sind Wellenleiter-Fotodiodenkombinationen angegeben, bei denen die einfallende Strahlung durch Stoßkopplung zwischen Wellenleiter und Fotodiode direkt auf die Fotodiode geleitet wird.

Eine Wellenleiter-Fotodiodenkombination, bei der die eine Komponente der Fotodiode aus einem Material besteht, das einen höheren Brechungsindex aufweist als das Material des Wellenleiters und das infolgedessen die einfallende Strahlung in die Fotodiode einkoppelt, ist in der EP-OS 0 187 979 beschrieben. Dabei ist auf einem Substratkörper aus InP, der entweder eine hinreichend glatt strukturierte Oberfläche aufweist oder bei dem eine zusätzliche InP-Schicht epitaktisch aufgebracht ist, eine Wellenleiterschicht aus einem quaternären Material, z.B. InGaAsP, aufgebracht. Auf dem Schichtwellenleiter ist eine Fotodiode ausgebildet, die aus ternärem Material, z.B. InGaAs, besteht. Diese Fotodiode besteht entweder aus zwei epitaktisch nacheinander aufgebrachten Schichten, von denen die eine wie der Rest des Bauelementes n-dotiert ist, während die andere, darüberbefindliche Schicht eine p-Dotierung aufweist, oder die Fotodiode besteht aus einer einzigen Schicht, die ursprünglich n-dotiert ist und in die von oben eine p-Dotierung, zum Beispiel durch Diffusion eingebracht worden ist. Diese Anordnung kann nach oben durch eine Schicht aus $Si_3N_4$, Polyimid oder InP abgedeckt sein.

Bei dieser Wellenleiter-Fotodiodenkombination befindet sich die Fotodiode in Mesastruktur an der Oberfläche des Bauelementes. Dieser Aufbau ist durch einen relativ hohen Dunkelstrom für die Fotodioden gekennzeichnet, was bei Einbau in optische Empfänger in einer schlechten Nachweisempfindlichkeit resultiert. Außerdem ist die Langzeitstabilität von planaren Fotodioden wesentlich höher als die von Fotodioden mit Mesastruktur.

In der DE OS 26 24 436 ist ein Lichtwellenleiter mit angeschlossenem Detektor beschrieben. In Fig. 4 dieser Patentanmeldung ist eine Halbleiteranordnung dargestellt, bei der der Fotodetektor aus einem Fototransistor besteht. Eine mittlere Schicht, die als Wellenleiter dient, bildet im Detektorbereich die p-dotierte Basiszone. Der Wellenleiter befindet sich zwischen Confinementschichten, die im Bereich des Detektors n-leitend dotiert und kontaktiert sind. Ein planarer Aufbau ist bei dieser Anordnung ebenfalls nicht vorgesehen.

Die durch die Erfindung zu lösende Aufgabe besteht darin, eine Wellenleiter-Fotodiodenkombination anzugeben, die eine höhere Empfindlichkeit und größere Langzeitstabilität besitzt und kostengünstig in hoher Stückzahl herstellbar ist.

Diese Aufgabe wird durch die Merkmale des Patentanspruches 1 gelöst.

Die vorliegende Erfindung löst die angebene Aufgabenstellung, indem die Fotodiode in den Wellenleiter integriert wird, und zwar so, daß die Strahlung aus dem Wellenleiter durch Leckwellenkopplung in die Fotodiode eingekoppelt wird. Dabei wird die Fotodiode in den Wellenleiter selbst sowie das darunter befindliche Trägersubstrat integriert. Der Aufbau dieser Wellenleiter-Fotodiodenkombination besteht aus einem Trägersubstrat, das aus Halbleitermaterial besteht und gegebenenfalls zur Verbesserung der Oberfläche mit einer epitaktisch aufgewachsenen Schicht aus demselben Halbleitermaterial versehen ist, und einem darauf aufgebrachten Wellenleiter aus einem Material mit einem höheren Brechungsindex. In das Trägersubstrat ist in einem ausgeätzten Graben ein Halbleitermaterial aufgewachsen, das einen gegenüber dem Wellenleiter höheren Brechungsindex besitzt und n-leitend dotiert ist. Diese grabenförmige Schicht bildet die Absorptionsschicht für die Fotodiode. Die Fotodiode ist ausgebildet, indem durch Aussparungen in einer Deckschicht aus $Si_3N_4$ p-Dotierung in den Wellenleiter, zum Beispiel durch Diffusion oder Implantation, eingebracht ist. Dieser Bereich p-leitender Dotierung muß mindestens bis zu der in dem ausgeätzten Graben verlaufenden Absorptionsschicht reichen. Der Übergang zwischen dem Bereich p-leitender Dotierung und dem n-leitenden Bereich der Absorptionsschicht liegt auf der Grenze zwischen Wellenleiter und Absorptionsschicht oder in der Absorptionschicht. Zwischen dem Wellenleiter und der Deckschicht kann eine weitere Schicht aus dem Halbleitermaterial des Trägersubstrates aufgebracht sein. Über den Fotodioden sind die Kontakte für die positiven Elektroden angebracht. Falls das Trägersubstrat n-leitend dotiert ist, befinden sich die Kontakte der negativen Elektrode auf der Unterseite des Trägersubstrates. Ist das Trägersubstrat semiisolierend, ist der Kontakt für die negative Elektrode in einer Aussparung der Deckschicht außerhalb des von den Fotodioden eingenommenen Bereiches angebracht.

Ausführungsbeispiele für die verschiedenen Modifikationen eines erfindungsgemäßen Bauelementes auf der Basis eines InP-Substratträngers für die Übertragung im Wellenlängenbereich zwischen 1,3 $\mu$m und 1,5 $\mu$m werden im folgenden anhand der Fig. 1 bis 5 beschrieben.

Figur 1 zeigt eine Schnittansicht einer erfindungsgemäßen Wellenleiter-Fotodiodenkombination.

Die Figuren 2 bis 4 zeigen einzelne Weiterbildungen des Grundaufbaus jeweils im Querschnitt.

Figur 5 zeigt das Bauelement im Aufbau der Figur 3 in der Aufsicht mit Kontakten für die Elektroden.

Figur 6 zeigt das Bauelement aus Figur 5 in der Seitenansicht von links.

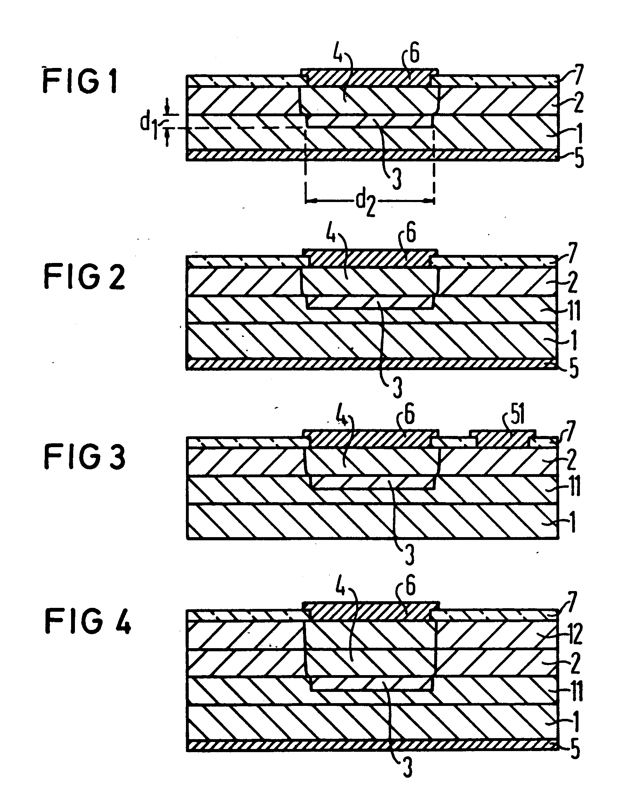

Bei dem Grundaufbau nach Figur 1 besteht das Trägersubstrat 1 aus n-leitend dotiertem InP mit der Dotierungskonzentration von typisch $5 * 10^{18}$ cm$^{-3}$ und (100)-Orientierung und ist so bemessen, daß eine ausreichende mechanische Stabilität des fertigen Bauelementes sichergestellt ist. In diesem Trägersubstrat 1 ist an der Oberfläche ein streifenförmiger Graben 3 der Tiefe $d_1$ von etwa 1 bis 2 $\mu$m und einer Breite von 200 bis 300 $\mu$m ausgeätzt. Dieser streifenförmige Graben ist epitaktisch mit einer Schicht aus In$_{0,53}$Ga$_{0,47}$As, das n-leitend mit einer Konzentration von typisch $5 * 10^{15}$ cm$^{-3}$ dotiert ist, aufgefüllt, so daß sich mit dem Trägersubstrat 1 eine ebene Oberfläche ergibt. Diese streifenförmige Halbleiterschicht bildet die n-leitende Absorptionsschicht 3 der Fotodioden.

Als nächste Schicht ist der Wellenleiter 2 aus InGaAsP aufgebracht, wobei die Dicke und Zusammensetzung dieser Schicht so gewählt wird, daß für Licht von 1,3 $\mu$m und 1,5 $\mu$m Wellenlänge ein Monomode-Schichtwellenleiter entsteht. Der Wellenleiter 2 ist nach oben mit einer als Diffusionsmaske dienenden Deckschicht 7 aus Si$_3$N$_4$ versehen. In dieser Deckschicht 7 sind über der n-leitenden Absorptionsschicht 3 Vierecke mit einer Kantenlänge $d_3$ von etwa 20 $\mu$m bis 500 $\mu$m ausgespart und in dem darunter befindlichen Wellenleiter 2 Gebiete mit p-leitender Dotierung 4 durch Diffusion ausgebildet. Der pn-Übergang liegt in der Grenzfläche zwischen dem Wellenleiter 2 und der n-leitenden Absorptionsschicht 3 oder geringfügig tiefer in dieser n-leitenden Absorptionsschicht 3. Bis auf die Bereiche der p-leitenden Dotierung und die Deckschicht 7 ist das gesamte Bauelement n-leitend dotiert.

Über den p-dotierten Bereichen sind in den Aussparungen der Deckschicht 7 Kontakte für die positive Elektrode 6 angebracht. Die Kontakte für die negative Elektrode 5 sind auf der freien Seite des Trägersubstrates 1 angebracht.

In der Ausführung nach Figur 2 ist zum Zwecke einer besseren Schichtqualität auf der Oberfläche des Trägersubstrates 1 eine weitere Schicht 11 aus n-leitendem InP von etwa 3 $\mu$m Dicke und einer Dotierungskonzentration von typisch $5 * 10^{18}$ cm$^{-3}$ aufgebracht. In diese weitere Schicht 11 ist die n-leitende Absorptionsschicht 3 integriert.

Eine Anordnung, bei der der Wellenleiter 2 auf beiden Seiten durch n-leitend dotierte InP-Schichten begrenzt ist, zeigt Figur 4. Zwischen Wellenleiter 2 und Deckschicht 7 ist eine zusätzliche Schicht 12 aus n-leitendem InP aufgebracht. Die p-leitende Dotierung zur Ausbildung der Fotodioden ist durch die zusätzliche Schicht 12 in den Wellenleiter 2 zum Beispiel durch Diffusion eingebracht.

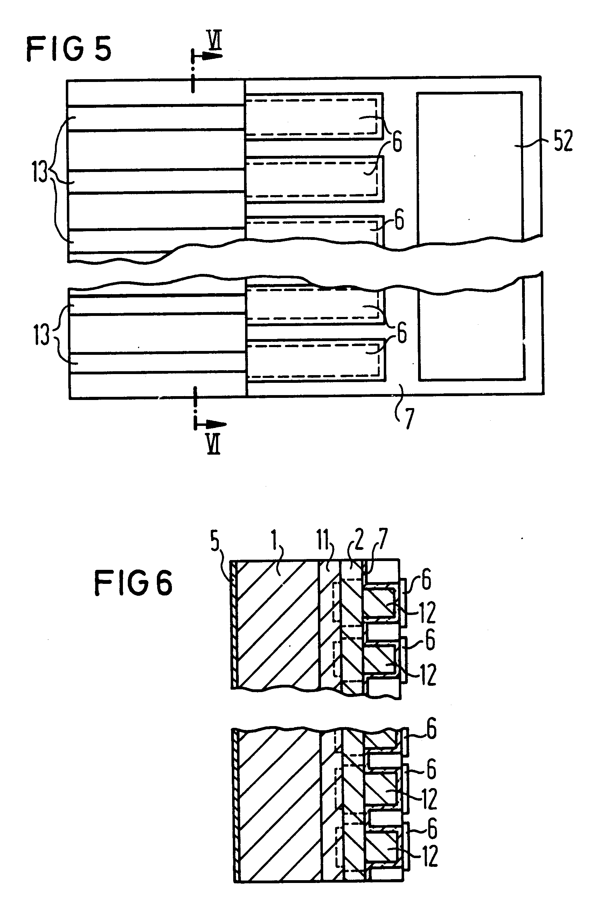

Das Trägersubstrat 1 kann statt aus n-leitend dotiertem Halbleitermaterial aus semiisolierendem InP-Material bestehen. Den zugehörigen Aufbau des Bauelementes zeigt Figur 3. Der Kontakt für die negative Elektrode 51 ist in diesem Fall in Aussparungen der Deckschicht 7 außerhalb des von den Fotodioden eingenommenen Bereiches auf dem Wellenleiter 2 angebracht. Diese Ausgestaltung des Bauelementes ist in Aufsicht in Figur 5 dargestellt.

Mehrere erfindungsgemäße Wellenleiter-Fotodiodenkombinationen können als Array angeordnet werden. Ein solches Wellenleiter-Fotodiodenarray in Aufsicht ist in Fig. 5 dargestellt. Der Wellenleiter ist als Streifenwellenleiter 13 ausgebildet. Diese Streifen können hergestellt werden, indem entweder die Wellenleiterschicht 2 entsprechend geätzt wird oder indem die weitere Schicht 12 in den Zwischenbereichen bis auf den Wellenleiter 2 heruntergeätzt wird. Die positiven Elektroden 6 der einzelnen Fotodioden sind auf den durch gestrichelte Linien markierten p-leitend dotierten Bereichen aufgebracht. Bei Verwendung eines semiisolierenden Trägersubstrates 1 ist die negative Elektrode 52 ebenfalls auf der Oberseite des Bauelementes aufgebracht. Der nicht mit Metallkontakten abgedeckte Teil der Oberfläche ist mit der Deckschicht 7 abgedeckt. Die Streifenwellenleiter 13 können in y-förmiger Weise zu einem oder mehreren Hauptwellenleitern zusammengeführt werden. Zusätzlich können in den Streifenwellenleitern 13 wellenlängenselektive Gitter oder Gitterstrukturen integriert sein. Damit ist sichergestellt, daß den jeweiligen Fotodioden nur Licht bestimmter Wellenlängen zugeführt wird. Fig. 6 zeigt das Bauelement aus Fig. 5 in der Seitenansicht von links. Der Übersichtlichkeit halber ist eine Ausführungsform gezeigt, bei der die negative Elektrode 5 auf der Unterseite des Trägersubstrates 1 angebracht ist.

**Patentansprüche**

1. Monolithisch integrierte Wellenleiter-Fotodiodenkombination, bei dem auf einem gemeinsamen Trägersubstrat (1) aus Halbleitermaterial ein Wellenleiter (2) zur Führung elektromagnetischer Wellen und mindestens eine an den Wellenleiter (2) gekoppelte Fotodiode mit einem Bereich p-leitender Dotierung (4) und einer n-leitenden Absorptionsschicht (3) ausgebildet sind,

**dadurch gekennzeichnet,**

- daß das Trägersubstrat (1) aus einem ersten Halbleitermaterial und der Wellenleiter (2) aus einem zweiten Halbleitermaterial besteht,
- daß der Brechungsindex des ersten Halbleitermaterials niedriger ist als der Brechungsindex des zweiten Halbleitermaterials,
- daß die n-leitende Absorptionsschicht (3) der Fotodiode streifenförmig ausgebildet ist und sich in dem Trägersubstrat (1) angrenzend an den Wellenleiter (2) befindet,
- daß das Material der n-leitenden Absorptionsschicht (3) einen höheren Brechungsindex als das Material des Wellenleiters (2) besitzt,
- daß die p-leitende Dotierung (4) der Fotodiode in der lichtführenden Schicht des Wellenleiters (2) liegt,
- daß dieser Bereich p-leitender Dotierung (4) mindestens bis zur Grenzfläche zur n-leitenden Absorptionsschicht (3) ausgebildet ist und
- daß durch diese Maßnahmen die Fotodiode in planarem Aufbau realisiert ist.

2. Monolithisch integrierte Wellenleiter-Fotodiodenkombination nach Anspruch 1,
**dadurch gekennzeichnet,**
daß als Passivierungsschicht und Diffusionsmaske für vorgesehene Kontakte für die positive Elektrode (6) eine $Si_3N_4$-Schicht (7) auf dem Wellenleiter (2) aufgebracht ist.

3. Monolithisch integrierte Wellenleiter-Fotodiodenkombination nach Anspruch 1 oder 2,
**dadurch gekennzeichnet,**
- daß zur Verbesserung der Schichtqualität das Trägersubstrat (1) an der Grenzfläche zum Wellenleiter (2) mit einer epitaktisch aufgebrachten weiteren Schicht (11) aus dem gleichen Material wie der übrige Teil des Trägersubstrates (1) versehen ist und
- daß die n-leitende Absorptionsschicht (3) in diese weitere Schicht (11) integriert ist.

4. Monolithisch integrierte Wellenleiter-Fotodiodenkombination nach einem der Ansprüche 1 bis 3,
**dadurch gekennzeichnet,**
daß das Trägersubstrat (1) InP ist.

5. Monolithisch integrierte Wellenleiter-Fotodiodenkombination nach einem der Ansprüche 1 bis 4,

**dadurch gekennzeichnet,**
daß das Trägersubstrat (1) semiisolierendes Halbleitermaterial ist.

6. Monolithisch integrierte Wellenleiter-Fotodiodenkombination nach einem der Ansprüche 1 bis 5,
**dadurch gekennzeichnet,**
daß der Wellenleiter (2) aus InGaAsP und die in dem Trägersubstrat (1) befindliche n-leitende streifenförmige Absorptionsschicht (3) der Fotodiode aus InGaAs besteht.

7. Monolithisch integrierte Wellenleiter-Fotodiodenkombination nach einem der Ansprüche 1 bis 6,
**dadurch gekennzeichnet,**
daß auf dem Wellenleiter (2) eine zusätzliche Schicht (12) aus demselben Halbleitermaterial, aus dem das Trägersubstrat (1) besteht, aufgebracht ist, so daß der Wellenleiter (2) beidseitig von diesem Halbleitermaterial umgeben ist.

8. Array aus mehreren monolithisch integrierten Wellenleiter-Fotodiodenkombinationen nach einem der Ansprüche 1 bis 7, bei dem der Wellenleiter (2) jeweils als Streifenwellenleiter (13), der jeweils zu einer vorgesehenen Fotodiode führt, ausgebildet ist, und bei dem diese Streifenwellenleiter (13) in y-förmiger Weise zu einem oder mehreren Hauptwellenleitern zusammengeführt werden.

9. Array nach Anspruch 8, bei dem in den Streifenwellenleitern (13) wellenlängenselektive Gitter oder Gitterstrukturen integriert sind.

**Claims**

1. Monolithically integrated waveguide-photodiode combination, in which a waveguide (2), for carrying electromagnetic waves, and at least one photodiode, which is coupled to the waveguide (2) and has a region of p-conductive doping (4), and an n-conductive absorption layer (3), are constructed on a common carrier substrate (1) consisting of semiconductor material, characterised in that,
- the carrier substrate (1) is composed of a first semiconductor material and the waveguide (2) is composed of a second semiconductor material, in that
- the refractive index of the first semiconductor material is lower than the refractive index of the second semiconductor material, in that
- the n-conductive absorption layer (3) of the photodiode is constructed in the form of strips and is located in the carrier substrate (1) adjacent to the waveguide (2), in that
- the material of the n-conductive absorption layer (3) has a higher refractive index than the material of the waveguide (2), in that
- the p-conductive doping (4) of the photodiode is located in the light-carrying layer of the waveguide (2), in that
- this region of p-conductive doping (4) is constructed at least up to the boundary surface to the n-conductive absorption layer (3), and in that
- a photodiode of planar construction is implemented by these measures.

2. Monolithically integrated waveguide-photodiode combination according to Claim 1, characterised in that an Si₃N₄ layer (7) is deposited on the waveguide (2) as a passivation layer and as a diffusion mask for the contacts which are provided for the positive electrode (6).

3. Monolithically integrated waveguide-photodiode combination according to Claim 1 or 2, characterised in that
- in order to improve the layer quality, the carrier substrate (1) is provided on the boundary surface of the waveguide (2) with a further layer (11) which is epitaxially deposited and is composed of the same material as the other part of the carrier substrate, and in that
- the n-conductive absorption layer (3) is integrated into this further layer (11).

4. Monolithically integrated waveguide-photodiode combination according to one of Claims 1 to 3, characterised in that the carrier substrate (1) is InP.

5. Monolithically integrated waveguide-photodiode combination according to one of Claims 1 to 4, characterised in that the carrier substrate (1) is a semiinsulating semiconductor material.

6. Monolithically integrated waveguide-photodiode combination according to one of Claims 1 to 5, characterised in that the waveguide (2) is composed of InGaAsP, and the n-conductive strip-shaped absorption layer (3) of the photodiode, which is located in the carrier substrate (1), is composed of InGaAs.

7. Monolithically integrated waveguide-photodiode combination according to one of Claims 1 to 6, characterised in that an additional layer (12) is deposited on the waveguide (2), which layer (12) is composed of the same semiconductor material as the carrier substrate (1), so that the waveguide (2) is surrounded by this semiconductor material on both sides.

8. Array comprising a plurality of monolithically integrated waveguide-photodiode combinations according to one of Claims 1 to 7, in which the waveguide (2) is constructed in each case as a stripline waveguide (13), which in each case leads to a photodiode which is provided, and in which said stripline waveguides (13) are combined in a y-shaped manner to form one or more main waveguides.

9. Array according to Claim 8, in which wavelength-selective grids or grid structures are integrated into the stripline waveguides (13).

**Revendications**

1. Combinaison intégrée monolithique guide d'ondes-photodiodes, dans laquelle un guide d'ondes (2) servant à guider des ondes électromagnétiques et au moins une photodiode couplée à un guide d'ondes (2) possédant une zone ayant un dopage (4) conducteur du type p et une couche d'absorption (3) conductrice de type n sont formés sur un substrat de support commun (1) d'un matériau semiconducteur, caractérisée par le fait
- que le substrat de support (1) est constitué par un premier matériau semiconducteur et que le guide d'ondes (2) est constitué par un second matériau semiconducteur,
- que l'indice de réfraction du premier matériau semiconducteur est inférieur à l'indice de réfraction du second matériau semiconducteur,
- que la couche d'absorption (3) de type n de la photodiode est réalisée sous la forme d'une bande et est située dans le substrat de support (1) en étant contiguë au guide d'ondes (2),
- que le matériau de la couche d'absorption (3) conductrice de type n possède un indice de réfraction supérieur à celui du matériau du guide d'ondes (2),
- que le dopage (4) conducteur de type p de la photodiode est situé dans la couche du guide d'ondes (2) qui guide la lumière,

- que cette zone, qui possède un dopage (4) conducteur de type p, s'étend au moins jusqu'à la surface limite avec la couche d'absorption (3) conductrice de type n; et
- que, grâce à ces dispositions, la photodiode est réalisée avec une constitution planar.

2. Combinaison intégrée monolithique guides d'ondes-photodiodes suivant la revendication 1, caractérisée par le fait qu'une couche (7) de $Si_3N_4$ est disposée en tant que couche de passivation et masque de diffusion pour des contacts prévus pour l'électrode positive (6), sur le guide d'ondes (2).

3. Combinaison intégrée monolithique guides d'ondes-photodiodes suivant la revendication 1 ou 2, caractérisée par le fait
    - que pour améliorer la qualité des couches, le substrat de support (1) comporte, au niveau de l'interface avec le guide d'ondes (2), une autre couche (11) déposée par épitaxie et formée par le même matériau que l'autre partie du substrat de support (1), et
    - que la couche d'absorption (3) conductrice de type n est intégrée dans cette autre couche (11).

4. Combinaison intégrée monolithique guides d'ondes-photodiodes suivant l'une des revendications 1 à 3, caractérisée par le fait que le substrat de support (1) est du InP.

5. Combinaison intégrée monolithique guides d'ondes-photodiodes suivant l'une des revendications 1 à 4, caractérisée par le fait que le substrat de support (1) est un matériau semiconducteur semi-isolant.

6. Combinaison intégrée monolithique guides d'ondes-photodiodes suivant l'une des revendications 1 à 5, caractérisée par le fait que le guide d'ondes (2) est formé de InGaAsP et que la couche d'absorption en forme de bande (3), conductrice du type n et située sur le substrat de support (1), de la photodiode, est constituée par du InGaAS.

7. Combinaison intégrée monolithique de guides d'ondes-photodiodes suivant l'une des revendications 1 à 6, caractérisée par le fait que sur le guide d'ondes (2) est déposée une couche supplémentaire (12) formée du même matériau semiconducteur que celui dont est constitué le substrat de support (1), en sorte que le guide d'ondes (2) est entouré des deux côtés par ce matériau semiconducteur.

8. Réseau formé de plusieurs combinaisons intégrées monolithiques guide d'ondes-photodiodes suivant l'une des revendications 1 à 7, dans lequel le guide d'ondes (2) est réalisé sous la forme d'un guide d'ondes en forme de bande (13), qui aboutit respectivement à une diode prévue, et dans lequel ces guides d'ondes en forme de bandes (13) sont réunis selon une forme en y pour former un ou plusieurs guides d'ondes principaux.

9. Réseau suivant la revendication 8, dans lequel des réseaux ou des structures de réseaux sélectifs du point de vue de la longueur d'onde sont intégrés dans les guides en forme de bandes (13).

EP 0 278 408 B1

FIG 1

FIG 2

FIG 3

FIG 4

7

FIG 5

13

13

6

6

6

6

52

7

VI

VI

FIG 6

5  1  11  2  7

6

12

6

12

6

6

12

6

12